Europäisches Patentamt

European Patent Office

Office européen des brevets

(19)

(11) **EP 0 703 688 B1**

(12) **EUROPÄISCHE PATENTSCHRIFT**

(45) Veröffentlichungstag und Bekanntmachung des Hinweises auf die Patenterteilung:
**12.01.2000 Patentblatt 2000/02**

(51) Int Cl.⁷: **H04L 27/227**

(21) Anmeldenummer: **95114170.4**

(22) Anmeldetag: **09.09.1995**

(54) **Phasendetektor für die Steuerung der Rückgewinnung eines Trägersignals**

Phasedetector for carrier recovery control

Détecteur de phase pour le contrôle de la récupération de porteur

(84) Benannte Vertragsstaaten:
**AT BE CH DE FR GB IT LI**

(30) Priorität: **22.09.1994 DE 4433779**

(43) Veröffentlichungstag der Anmeldung:
**27.03.1996 Patentblatt 1996/13**

(73) Patentinhaber: **GRUNDIG Aktiengesellschaft 90762 Fürth (DE)**

(72) Erfinder: **Vanselow, Frank, Grundig E.M.V. D-90762 Fürth (DE)**

(56) Entgegenhaltungen:
**US-A- 4 169 246        US-A- 4 466 109**
**US-A- 4 484 337        US-A- 4 559 499**

- **PATENT ABSTRACTS OF JAPAN vol. 011 no. 338 (E-553) ,5.November 1987 & JP-A-62 118660 (KOKUSAI DENSHIN DENWA CO LTD) 30.Mai 1987,**
- **PATENT ABSTRACTS OF JAPAN vol. 010 no. 317 (E-449) ,28.Oktober 1986 & JP-A-61 125262 (HITACHI LTD) 12.Juni 1986,**

**Beschreibung**

Die vorliegende Erfindung betrifft einen Phasendetektor für die Steuerung der Rückgewinnung eines Trägersignals zur Demodulation eines QPSK-modulierten Signals, mit den Merkmalen des Oberbegriffs von Patentanspruch 1.

Für die Demodulation eines mit komplexen Symbolen modulierten Trägersignals (QPSK: Quadratur Phase Shift Keying) wird in den meisten Fällen - da in der Regel für eine fehlerfreie Demodulation keine Abweichung von Frequenz und Phase zwischen dem Trägersignal auf Sende- und Empfangsseite bestehen darf - ein spannungsgesteuerter Oszillator verwendet. Mit dem vom Oszillator erzeugten Trägersignal und einem dazu um 90° verschobenen Signal wird das empfangene Signal, bzw. ein davon abgeleitetes Zwischenfrequenzsignal, mittels Mischern in das Basisband umgesetzt und demoduliert.

Der zur Rückgewinnung des Trägersignals im Empfänger verwendete Oszillator wird mittels einer Regelspannung gesteuert, die aus dem Zf-Signal oder dem Basisbandsignal gewonnen wird. Zur Erzeugung der Regelspannung sind Fehlerdetektoren mit und ohne Rückkopplung bekannt und werden beispielsweise in "Digitale Modulationsverfahren" von R. Mäusel, 2. Aufl., 1988, Hüthig-Verlag Heidelberg, beschrieben. Die rückgekoppelten Fehlerdetektoren bieten dabei generell den Vorteil, daß die Regelgröße (hier: der Phasenfehler) sehr klein wird.

Phasendetektoren sind auch aus US-A-4 559 499 und US-A-4 466 109 bekannt, eine Trägerrückgewinnung aus US-A-4 484 337.

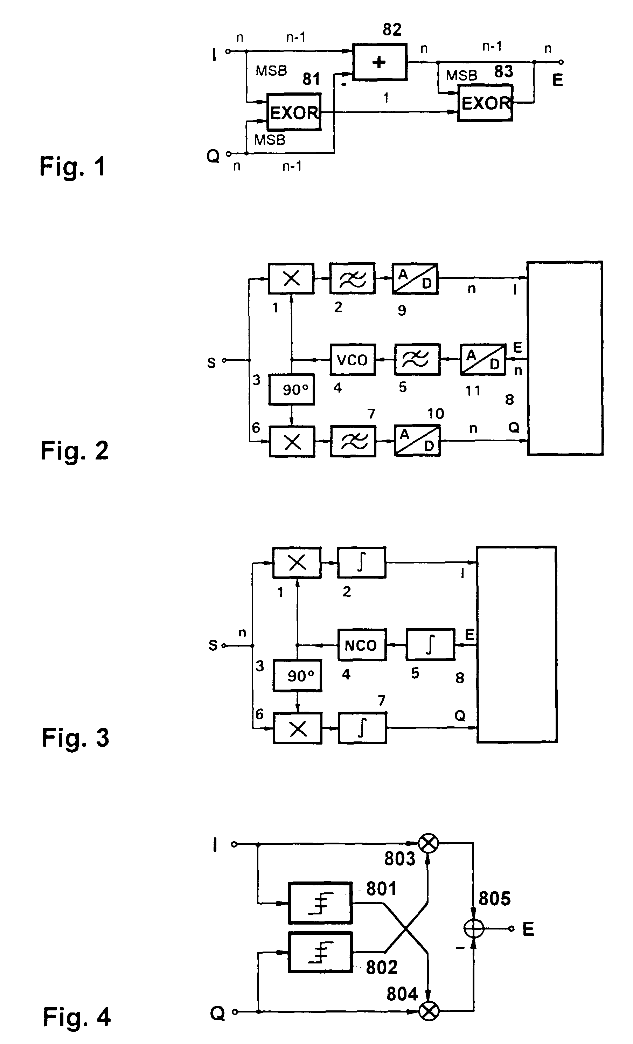

In Figur 2 ist der prinzipielle Aufbau eines Demodulators mit einem rückgekoppelten Phasendetektor dargestellt. Zunächst werden die Wandler 9, 10, und 11 nicht berücksichtigt.

Ein Modulationssignal S wird mittels zweier Mischer 1 und 6 demoduliert. Dazu wird am Mischer 1 das von einem spannungsgesteuerten Oszillator 4 erzeugte Trägersignal und am Mischer 6 ein mittels eines Phasenschiebers 3 um 90° gegenüber dem Trägersignal versetztes Signal angelegt. Nach einer Tiefpaßfilterung mittels der Filter 2 und 7 stehen das Inphasen- und Quadraturphasensignal I und Q zur weiteren Verarbeitung zur Verfügung. Aus Inphasen- und Quadraturphasensignal I und Q wird in einem Phasendetektor 8 ein Steuersignal E erzeugt, dessen Spannung, nach einer Tiefpaßfilterung mit dem Filter 5, den Oszillator 4 steuert.

Figur 4 stellt den Aufbau eines bekannten Phasendetektors, des sogenannten "Costas-Loop", dar. Mittels zweier Entscheider 801 und 802 werden die Signalwerte von Inphasen- und Quadraturphasensignal I und Q bestimmt und überkreuz mittels zweier Multiplizierer 803 und 804 mit dem Inphasen- bzw. Quadraturphasensignal I und Q multipliziert. Aus den Signalen der Ausgänge der Multiplizierer 803 und 804 wird mittels eines Subtrahierers 805 das Steuersignal E gebildet. Man unterscheidet zwischen "hartem" und "weichem" Costas-Loop. Beim "harten" Costas-Loop wird mittels der Entscheider 801 und 802 nur das Vorzeichen von Inphasen- und Quadraturphasensignal ermittelt, während beim "weichen" Costas-Loop neben dem Vorzeichen auch die Amplitudenwerte ermittelt werden. Dabei nehmen die Entscheider 801 und 802 eine Quantisierung der Amplitudenwerte vor. Den Amplitudenwerten werden die Werte zugewiesen, welche die einzelnen Signalwerte ohne Störeinwirkungen wie Rauschen oder Abweichung der Phase des rückgewonnenen Trägersignals aufweisen würden.

Neben dem in den Figuren 2 und 4 dargestellten analogen Aufbau (Figur 2 ohne Berücksichtigung der Wandler 9, 10, 11) wird häufig auch ein digitaler Aufbau verwendet. Für diesen Fall stellen die Figuren 2 und 3 mögliche Ausgestaltungsformen für Demodulatoren dar.

In Figur 2 sind zu diesem Zweck zusätzlich zwei Analog/Digital-Wandler 9 und 10, welche die Signale I und Q mit der im System verwendeten Wortlänge von n Bit digitalisieren, und ein Analog/Digital-Wandler 11 vorgesehen.

Die Funktionsweise entspricht der oben für den analogen Aufbau beschriebenen Funktion, mit dem Unterschied, daß das Steuersignal E aus den digitalen Inphasen- und Quadraturphasensignalen I und Q gebildet wird. Entsprechend muß der in Figur 4 dargestellte Phasendetektor aus digitalen Komponenten aufgebaut sein.

Figur 3 stellt einen vollständig digital aufgebauten Demodulator dar. Ein digitales Modulationssignal S, mit einer Wortbreite von n Bit, wird mittels zweier Multiplizierer 1 und 6 mit dem Signal eines numerisch gesteuerten Oszillators 4 und einem dazu um 90° verschobenen Signal multipliziert. Die so gewonnenen Signale werden mittels der Integratoren 2 und 7 geglättet und ergeben das Inphasen- und Quadraturphasensignal I und Q. Das vom Phasendetektor 8 gebildete Steuersignal E wird ebenfalls mittels eines Integrators 5 geglättet und steuert den numerischen Oszillator 4, der beispielsweise durch einen Vorwärts/Rückwärtszähler gebildet werden kann.

Sollen QPSK modulierte Signale hoher Datenrate demoduliert werden, ergibt sich für den bekannten Phasendetektor, sowohl in analoger als auch in digitaler Ausführungsform, ein hoher Realisierungsaufwand, der aus der Verwendung von Multiplizierern und Entscheidern resultiert.

Aufgabe der vorliegende Erfindung ist es deshalb, einen Phasendetektor für die Steuerung der Rückgewinnung eines Trägersignals zur Demodulation eines QPSK modulierten Signals anzugeben, der auch für hohe Datenraten ohne großen Schaltungsaufwand realisiert werden kann.

Erfindungsgemäß wird diese Aufgabe durch die Merkmale des Patentanspruchs 1 gelöst.

Der Vorteil der Erfindung liegt insbesondere darin, daß der erfindungsgemäße Phasendetektor durch die Verwendung einfacher Logik-Schaltugen realisiert werden kann, wodurch der Schaltungsaufwand auch für hohe Datenraten sehr gering ist.

Weitere Vorteile der Erfindung ergeben sich aus dem Unteranspruch und der nachfolgenden Beschreibung und Erläuterung anhand von Figuren.

Es zeigen:

Figur 1 einen erfindungsgemäßen Phasendetektor,

Figur 2 den Aufbau eines Demodulators,

Figur 3 den Aufbau eines digitalen Demodulators, und

Figur 4 den Aufbau eines Phasendetektors nach Costas.

Der in Figur 1 dargestellte erfindungsgemäße Phasendetektor weist eine erste Exulsiv-Oder-Schaltung 81 auf, an deren Eingängen die höchstwertigen Bit MSB des Inphasen- und Quadraturphasensignals I und Q anliegen. Inphasen- und Quadraturphasensignal I und Q haben je eine Wortlänge von n Bit, wobei das höchstwertige Bit MSB die Vorzeicheninformation enthält, die restlichen n-1 Bit enthalten den Amplitudenwert (Betrag). Mittels eines Subtrahierers 82 werden die n-1 Bit des Quadraturphasensignals Q von den n-1 Bit des Inphasensignals I subtrahiert. Das Ausgangssignal des Subtrahierers 82 weist wegen der sich bei der Subtraktion ergebenden Vorzeicheninformation wieder n Bit auf. Das höchstwertige Bit MSB des Ausgangssignals des Subtrahierers 82 und das Ausgangssignal der ersten Exklusiv-Oder-Schaltung 81 sind mit den Eingängen einer zweiten Exklusiv-Oder-Schaltung 83 verbunden. Das Steuersignal E wird vom Ausgangssignal der zweiten Exklusiv-Oder-Schaltung 83 und dem Ausgangssignal des Subtrahierers 82 gebildet, wobei das Ausgangssignal der zweiten Exklusiv-Oder-Schaltung 83 das höchstwertige Bit des Steuersignals E und die n-1 Bit des Subtrahierers 82 die restlichen n-1 Bit der n Bit breiten Digitalworte des Steuersignals E bilden.

Zur Erläuterung der Funktionsweise werden nachfolgend die Vorzeichen von Inphasen- und Quadraturphasensignal mit der sgn-Funktion dargestellt. Für die sgn-Funktion gilt:

$$\operatorname{sgn}(x) = \begin{cases} 1 & \text{für} \quad x > 0 \\ 0 & \text{für} \quad x = 0 \\ -1 & \text{für} \quad x < 0 \end{cases}$$

Das Steuersignal E für den in Figur 4 dargestellten "harten" Costas-Loop ergibt sich somit aus folgender Gleichung (die Signalwerte I und Q werden in Amplitudenbetrag und Vorzeichen aufgespalten, z.B. I=|I|·sgn(I)) :

$$E = (|I|-|Q|) \cdot \operatorname{sgn}(I) \cdot \operatorname{sgn}(Q)$$

Beim erfindungsgemäßen Phasendetektor wird durch die Exklusiv-Oder-Schaltung 81 die Vorzeicheninformation in den höchstwertigen Bit MSB von Inphasen- und Quadraturphasensignal (entsprechend: sgn(I)·sgn(Q)) ausgewertet. Der Subtrahierer 82 erzeugt den Differenzwert der Amplitudenbeträge (entsprechend: |I|-|Q|) von Inphasenamplitude (|I|) minus Quadraturphasenamplitude (|Q|), deren Beträge in den restlichen n-1 Bit der n Bit breiten Worte der digitalen Inphasen- und Quadraturphasensignale enthalten sind. Anschließend wird die Vorzeicheninformation der Subtraktion (mit folgender Umformung: |I|-|Q|=|||I|-|Q|||·sgn (|I|-|Q|) , somit gibt der Term sgn(|I|-|Q|) die Vorzeicheninformation der Subtraktion an, der Term |||I|-|Q|| die Amplitude) mit der von der ersten Exklusiv-Oder-Schaltung 81 gebildeten Vorzeicheninformation von der zweiten Exkulsiv-Oder-Schaltung 83 zur Vorzeicheninformation des Steuersignals E zusammengefaßt. Die Amplitude des Steuersignals E wird von der Amplitude des Subtrahierers 82 gebildet, also von den restlichen n-1 Bit des Ausgangssignals des Subtrahierers 82.

Aus der beschriebenen Ausführungsform des erfindungsgemäßen Phasendetektors ergeben sich für den Fachmann in naheliegender Weise weitere Ausgestaltungsmöglichkeiten. Beispielsweise kann der Aufbau des Phasendetektors ohne weiteres für abweichende Formate des verwendeten digitalen Worts (anderer Aufbau von Vorzeicheninformation und Signalwert) realisiert werden.

**Patentansprüche**

1. Phasendetektor (8) für die Steuerung der Rückgewinnung eines Trägersignals zur Demodulation eines QPSK modulierten Signals (S), wobei der Phasendetektor ein digitales Steuersignal (E) zur Steuerung eines Oszillators (4) aus einem digitalen Inphasensignal (I) und einem digitalen Quadraturphasensignal (Q) ableitet,
**dadurch gekennzeichnet**,
daß der Phasendetektor (8) aufweist

   • eine erste Exklusiv-Oder-Schaltung (81) zur Verknüpfung der Vorzeicheninformation von Inphasen- und Quadraturphasensignal,
   • einen Subtrahierer (82) zur Subtraktion der Amplitudenwerte (n-1) von Inphasen- und Quadraturphasensignal, und
   • eine zweite Exklusiv-Oder-Schaltung (83) zur Verknüpfung einer von der ersten Exklusiv-Oder-Schaltung (81) gebildeten Vorzeicheninformation mit einer vom Subtrahierer (82) gebildeten Vorzeicheninformation,

wobei das Steuersignal (E) die von der zweiten Exklusiv-Oder-Schaltung (83) gebildete Vorzeicheninformation und den Amplitudenwert (n-1) des Ausgangssignals des Subtrahierers (82) umfaßt.

**2.** Phasendetektor nach Anspruch 1, **dadurch gekennzeichne**t, daß die digitalen Signale eine Wortlänge von n Bit aufweisen, wobei das höchstwertige Bit (MSB) die Vorzeicheninformation enthält und die restlichen n-1 Bit den Amplitudenwert.

## Claims

**1.** Phase detector (8) for carrier signal recovery control for the purpose of demodulating a QPSK-modulated signal (S), wherein the phase detector derives a digital control signal (E) for controlling an oscillator (4) from a digital in-phase signal (I) and a digital quadrature phase signal (Q),
characterized in that
the phase detector (8) comprises

- a first exclusive-OR circuit (81) for combining the sign information of in-phase signal and quadrature phase signal,
- a subtracter (82) for subtracting the amplitude values (n-1) of in-phase signal and quadrature phase signal, and
- a second exclusive-OR circuit (83) for combining sign information formed by the first exclusive-OR circuit (81) with sign information formed by the subtracter (82),

wherein the control signal (E) comprises the sign information formed by the second exclusive-OR circuit (83) and the amplitude value (n-1) of the output signal of the subtracter (82).

**2.** Phase detector according to Claim 1, characterized in that the digital signals have a word length of n bits, wherein the most significant bit (MSB) contains the sign information and the remaining n-1 bits contain the amplitude value.

## Revendications

**1.** Détecteur de phase (8) pour la commande de la récupération d'un signal de porteuse pour la démodulation d'un signal (S) modulé selon la modulation QPSK, le détecteur de phase dérivant un signal de commande (P) pour la commande d'un oscillateur (4) à partir d'un signal numérique en phase (I) et d'un signal numérique en quadrature de phase (Q), caractérisé en ce que le détecteur de phase (8) comporte :

- un premier circuit OU-Exclusif (81) pour combiner les informations de signe du signal en phase et du signal en quadrature de phase,
- un soustracteur (82) pour soustraire les valeurs d'amplitude (n-1) du signal en phase et du signal en quadrature de phase, et
- un second circuit OU-Exclusif (83) pour combiner une information de signe formée par le premier circuit OU-Exclusif (81) à une information de signe formée par le soustracteur (82),

le signal de commande (E) comprenant l'information de signe formée sur le second circuit OU-Exclusif (81) et la valeur d'amplitude (n-1) du signal de sortie du soustracteur (82).

**2.** Détecteur de phase selon la revendication 1, caractérisé en ce que les signaux numériques possèdent une longueur de mot de n bits, le bit de poids maximum (MSB) contenant l'information de signe et les n-1 autres bits contenant la valeur d'amplitude.

**Fig. 1**

**Fig. 2**

**Fig. 3**

**Fig. 4**